(19) **Europäisches Patentamt / European Patent Office / Office européen des brevets**

(11) **EP 3 026 453 B1**

(12) **FASCICULE DE BREVET EUROPEEN**

(45) Date de publication et mention
de la délivrance du brevet:
**09.01.2019 Bulletin 2019/02**

(51) Int Cl.:
**G01S 1/02** (2010.01) **G01R 29/10** (2006.01)

(21) Numéro de dépôt: **15195009.4**

(22) Date de dépôt: **17.11.2015**

(54) **PROCEDE DE GENERATION D'UNE CARTOGRAPHIE DE COUVERTURE D'EMISSION OU DE RECEPTION D'UNE ANTENNE D'UNE STATION SOL POUR DES LIAISONS SATELLITE**

**VERFAHREN ZUR ERZEUGUNG EINER KARTOGRAPHIE DER SENDE- UND EMPFANGSABDECKUNG EINER ANTENNE EINER BODENSTATION FÜR SATELLITENVERBINDUNGEN**

**METHOD FOR GENERATING A MAP OF TRANSMISSION OR RECEPTION COVERAGE OF AN ANTENNA OF A GROUND STATION FOR SATELLITE LINKS**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.11.2014 FR 1461588**

(43) Date de publication de la demande:
**01.06.2016 Bulletin 2016/22**

(73) Titulaire: **Eutelsat S.A.**
**75015 Paris (FR)**

(72) Inventeurs:
• **ARCIDIACONO, Antonio**
**75016 Paris (FR)**
• **FINOCCHIARO, Daniele Vito**
**75015 Paris (FR)**
• **LE PERA, Alessandro**
**92130 Issy-Les-Moulineaux (FR)**

• **SCHURIG, Fritz**
**78510 Triel-sur-Seine (FR)**

(74) Mandataire: **Cabinet Camus Lebkiri**
**25 rue de Maubeuge**
**75009 Paris (FR)**

(56) Documents cités:
**EP-A1- 2 629 439 DE-A1- 3 422 851**
**FR-A1- 2 739 191**

• **MICHAEL NYGAARD PEDERSEN ET AL: "Three-dimensional radiation pattern measurement strategy for ground station antennas", INTERNATIONAL JOURNAL OF SATELLITE COMMUNICATIONS AND NETWORKING, vol. 31, no. 1, 4 janvier 2013 (2013-01-04), pages 39-50, XP055196603, ISSN: 1542-0973, DOI: 10.1002/sat.1020**

## Description

## DOMAINE

Le domaine de l'invention concerne les méthodes de mesures de puissances et de diagrammes d'émission d'une antenne pour établir une cartographie de couverture de ladite antenne. Notamment, le domaine de l'invention concerne les tests d'émission et réception d'une antenne d'un émetteur d'une station au sol pour l'établissement d'une cartographie représentant une zone de couverture pour la transmission de données.

## ETAT DE L'ART

On entend par « diagramme de rayonnement » d'une antenne les différentes puissances reçues d'un signal de test $S_{test}$ dans un récepteur en faisant varier l'orientation de l'antenne de l'émetteur. Lorsque toutes les mesures sont effectuées, il est possible d'établir une cartographie de couverture de l'antenne qui est testée. Une cartographie de couverture est très utile dans la mesure où lorsqu'on connait les positions de l'émetteur et du récepteur et les orientations des antennes, il est possible d'ajuster la puissance d'émission nécessaire afin d'établir une liaison radiofréquence entre les différents éléments d'un système de radiocommunication.

Actuellement, il existe des solutions pour effectuer des tests d'antenne visant à établir un diagramme de rayonnement de ces dernières notamment pour des liaisons sol-satellite et réciproquement des liaisons satellite-sol.

Un test important consiste à valider la zone de couverture terrestre des émissions et réceptions des antennes de satellites et à valider la couverture des antennes au sol en émission et en réception vers des satellites.

Une problématique des tests d'antennes, tels que les tests permettant de vérifier les diagrammes de rayonnement et les niveaux d'émission, se pose dès lors que les mesures font intervenir une liaison de radiocommunication par satellite. En effet, ces tests sont connus pour générer des perturbations et interférences dans un environnement avoisinant les équipements testés ou le satellite.

En effet, ces tests sont idéalement effectués pendant que le satellite est opérationnel, c'est-à-dire qu'aucune interruption de service ne doit être planifiée ou subie.

Par ailleurs, la réalisation de ce type de tests est généralement encadrée par des réglementations imposant des niveaux limités de puissance, de ce fait les tests de couverture d'antenne sont difficiles à mettre en oeuvre car ils nécessitent généralement une configuration dans laquelle les puissances d'émission sont élevées.

Un autre problème provient des interférences causées sur le système testé. En effet, les antennes sont susceptibles de recevoir d'autres ondes radiofréquences perturbant les mesures durant les tests. C'est notamment le cas lorsque les mesures sont effectuées en limite de portée des antennes ou que les niveaux des signaux de tests deviennent faibles ou sont noyés dans le niveau de bruit.

Enfin, ces tests en émission causent souvent eux-mêmes des interférences sur d'autres systèmes tiers, ce qu'on cherche à éviter.

De nombreuses méthodes existent à ce jour. En revanche, certaines méthodes comprennent des tests qui définissent de forts niveaux de puissance à émettre en direction du satellite, d'autres tests nécessitent l'émission de fortes puissances par le satellite. Les signaux de tests reçus par une station terrestre permettent notamment de qualifier la qualité des signaux émis et/ou reçus par le satellite, la directivité de l'antenne, la couverture de l'antenne, les niveaux admissibles, les saturations, etc.

Les tests permettant d'établir une cartographie de couverture d'une antenne peuvent être réalisés de différentes manières.

Il existe une solution permettant d'établir une cartographie de couverture une antenne d'un satellite décrite dans le document de brevet EP 2 629 439. En revanche, cette solution qui permet de s'appuyer sur un signal à étalement de spectre est adaptée à l'établissement d'un diagramme d'une antenne d'un satellite et non à une antenne au sol.

Actuellement, il existe deux manières de procéder aux tests permettant d'établir le diagramme de rayonnement d'une antenne au sol dans une configuration dans laquelle la transmission s'effectue d'une première station au sol vers un satellite qui relaie la transmission vers une seconde station au sol.

Une première solution consiste à faire varier l'orientation de l'antenne d'émission au sol. Dans ce cas, les gains d'antenne de la station au sol en émission et celle du satellite sont fixes. La puissance reçue et mesurée au niveau de la station sol en réception donne le diagramme de rayonnement de l'antenne en émission de la station sol.

Une seconde solution consiste à faire varier l'orientation de l'antenne de réception au sol. Dans ce cas, l'orientation de l'antenne d'émission au sol est fixe et son gain est fixe. Le satellite peut introduire un gain fixe ou variable selon la configuration. Les mesures de puissance en réception permettent de déduire un diagramme de rayonnement de l'antenne en réception.

Le document XP055196603 "Three-dimensional radiation pattern measurement strategy for ground station antennas" de Michael Nygaard Pedersen et Al, décrit une méthode de mesure de diagramme d'antenne en trois dimension d'une antenne de station sol.

Cependant, aucune méthode ne permet de tester le diagramme de rayonnement d'une antenne au sol en liaison avec un satellite sans causer certaines perturbations à d'autres systèmes de radiocommunication avoisinant ledit satellite.

Le problème technique non résolu par l'art antérieur concerne la diminution des interférences causées sur des systèmes spatiaux environnants à un satellite que l'on souhaite solliciter dans une chaine de transmission afin d'effectuer des tests de couverture d'une antenne située au sol et communiquant avec le système satellite.

## RESUME DE L'INVENTION

L'invention permet de résoudre les inconvénients précités.

Un objet de l'invention concerne un procédé de mesure de gains d'antenne d'un émetteur d'une première station terrestre pour la génération d'au moins une cartographie de couverture de ladite antenne. En outre, le procédé comprend :

- Une pluralité d'émissions d'un signal de test par un émetteur d'une première station terrestre à destination d'un satellite comprenant un répéteur pour retransmettre le signal de test à une seconde station terrestre, les émissions de l'émetteur de la première station étant réalisées selon différentes orientations de l'antenne de l'émetteur, ledit signal de test étant modulé par étalement de spectre dans un canal d'une largeur prédéterminée par une séquence numérique pseudo-aléatoire codant au moins une séquence de bits de données générée par un calculateur de l'émetteur ;
- Une réception de chaque signal de test par un récepteur de la seconde station terrestre;
- Une démodulation de chaque signal de test permettant de mesurer la puissance reçue de chaque signal de test ;
- Une comparaison de chaque puissance avec un premier seuil de référence de puissance prédéfinie ;
- Une génération d'une consigne de codage visant à coder un nombre donné de séquences de bits de données par au moins une séquence pseudo-aléatoire dans un même signal de test lorsque ladite puissance reçue d'un signal de test est en dessous du premier seuil de puissance.

Un avantage est de permettre de réaliser un test de puissance d'antenne en émission pour chaque orientation de ladite antenne en adaptant automatiquement les conditions d'émission en fonction des caractéristiques d'une réception.

Un avantage du codage de la séquence de bits de données ou du nombre de séquences utilisées est d'améliorer les conditions de réception du signal en augmentation le gain de traitement en réception.

Selon un mode de réalisation, le signal de test généré comprend une pluralité de séquences PN, le nombre de séquence PN étant dépendant du niveau de puissance d'émission du signal de test et de l'orientation de l'antenne.

Selon un mode de réalisation, la séquence de bits de données est une séquence comprenant que des bits de valeurs égales à 1 de sorte que la séquence reçue corresponde à la séquence PN.

Selon un mode de réalisation, au moins une séquence de bits de données comprend des données codant l'orientation courante de l'antenne d'émission de l'émetteur de la première station terrestre, ledit procédé comprenant un décodage de la séquence de bits de données par un calculateur du récepteur de la seconde station terrestre pour assigner l'orientation angulaire courante de l'antenne de l'émetteur décodée à la puissance du signal de test mesurée en réception.

Selon un mode de réalisation, au moins une séquence de bits de données comprend, en outre, des données correspondant à la puissance d'émission de l'antenne de l'émetteur de la première station terrestre.

Selon un mode de réalisation, au moins une séquence de bits de données comprend, en outre, des données correspondant à la vitesse de balayage de l'antenne de l'émetteur de la première station terrestre.

Selon un mode de réalisation, au moins une séquence de bits de données comprend, en outre, des données correspondant à une calibration du signal de test émis par l'antenne de l'émetteur de la première station terrestre.

Selon un mode de réalisation, le procédé comprend une génération d'une consigne d'asservissement moteur permettant de piloter la vitesse de balayage de l'antenne de l'émetteur de la première station terrestre en fonction du niveau de puissance mesurée du signal de test reçu.

Selon un mode de réalisation, le procédé comprend une génération d'une consigne d'asservissement moteur permettant de piloter la vitesse de balayage de l'antenne de l'émetteur de la première station terrestre en fonction de l'orientation de l'antenne correspondante à la mesure de la puissance mesurée du signal de test reçu.

Selon un mode de réalisation, le signal de test comprend une composante d'onde co-polarisée, correspondante à la polarisation d'émission du signal et une composante d'onde cross-polarisée, correspondante à la polarisation orthogonale à la polarisation d'émission, le répéteur du satellite amplifiant lesdites deux polarisations, le récepteur de la seconde station au sol démodulant les deux composantes orthogonales du signal de test, la mesure du puissance du signal de test comprenant une mesure de la puissance de la composante de polarisation d'émission, ledit procédé comprenant en outre une étape de comparaison de ladite puissance de la composante de polarisation d'émission avec un second seuil de référence de puissance de manière à générer automatiquement une consigne de codage lorsque la valeur de la puissance est inférieure au second seuil de référence de puissance.

Selon un mode de réalisation, la mesure du puissance du signal de test comprend une mesure de puissance de la composante d'onde cross-polarisée du signal de test reçu par le récepteur de la seconde station terrestre et en ce qu'une comparaison du niveau de puissance reçue de ladite composante cross-polarisée avec un troisième seuil de référence de puissance permet de générer une consigne de synchronisation, ladite consigne de synchronisation permettant de prélever une donnée de référence fréquentielle et/ou une donnée de référence temporelle calculée à partir de la démodulation de la composante de polarisation d'émission.

Selon un mode de réalisation, la génération d'une consigne de synchronisation entraine la génération d'une consigne de codage.

Selon un mode de réalisation, au moins une consigne de codage et/ou au moins une consigne d'asservissement moteur est automatiquement transmise à un calculateur du l'émetteur de la première station terrestre par le biais d'un canal de retour.

Selon un mode de réalisation, le canal de retour est établi :

- Soit par l'intermédiaire d'un réseau terrestre ;
- Soit par l'intermédiaire d'un canal sans fil transitant par le satellite et transmis à un récepteur de la première station terrestre.

Selon un mode de réalisation, la vitesse de balayage de l'antenne de l'émetteur de la première station terrestre est coordonnée avec le nombre de séquences de bits de données codée par au moins une séquence pseudo aléatoire de sorte que le balayage de l'antenne comprend des durées de maintien de l'antenne à une orientation donnée suffisamment longues pour qu'un signal de test comprenant une pluralité de séquence de bits de données puisse être émis.

Selon un mode de réalisation, le nombre de séquence de bits de données est déterminé pour obtenir un gain de traitement souhaité en réception de l'antenne du récepteur de la seconde station terrestre.

Selon un mode de réalisation, une mesure des interférences amplifiées par le répéteur du satellite est effectuée en réception par l'antenne de réception afin de déduire un facteur de compensation des interférences pour chaque mesure de puissance reçue.

Un autre objet de l'invention concerne un procédé de génération d'un ensemble de mesures pour l'établissement de la cartographie d'un diagramme d'émission d'une antenne d'un émetteur d'une station terrestre, caractérisé en ce qu'un ensemble de mesures de puissances reçues des signaux de test par un récepteur d'une seconde station terrestre réalisé par le procédé de l'invention, lesdites mesures de puissance étant chacune associée à une orientation de l'antenne de l'émetteur de la première station terrestre et étant mémorisées dans une mémoire de la seconde station terrestre.

Un autre objet de l'invention concerne un système comprenant :

- une première station au sol comportant un générateur de signaux permettant de coder une première séquence de bits de données sur un signal de test à émettre à partir d'une première antenne ;
- un satellite comportant au moins une antenne de réception pour recevoir le signal de test, au moins un transpondeur pour réémettre le signal de test amplifié vers une seconde station terrestre ;
- une seconde station terrestre comportant au moins une antenne de réception et des moyens de calculs et de traitement du signal pour démoduler le signal de test reçu par le satellite et générer automatiquement une consigne de codage selon le procédé de l'invention.

Selon un mode de réalisation, la séquence de bits de données est un train de bits transmis à une vitesse entre 500bps et 10kbps.

Selon un mode de réalisation, les canaux d'émission entre l'émetteur de la première station terrestre vers le satellite et que les canaux de réception entre le satellite et le récepteur de la seconde station terrestre ont une largeur de bande comprises entre 20 et 120 MHz et que la fréquence centrale des canaux est comprise entre 1 GHz et 40GHz.

Selon un mode de réalisation, la première modulation par étalement de spectre comprend un taux d'encodage compris entre 4 et 80 Msymboles/s. Msymboles/s signifiant « million de symboles par seconde ». Le taux d'encodage est défini pour un nombre de symboles par seconde. Dans la terminologie scientifique il est aussi employé la dénomination Mchip/s.

Selon un mode de réalisation, la modulation par étalement de spectre est réalisée par l'utilisation de séquence de pseudo-bruit.

**BREVE DESCRIPTION DES FIGURES**

D'autres caractéristiques et avantages de l'invention ressortiront à la lecture de la description détaillée qui suit, en référence aux figures annexées, qui illustrent :

- figure 1 : un schéma représentant les différents éléments du système de l'invention pour mettre en oeuvre le procédé de l'invention ;
- figure 2 : une modulation d'une séquence de bits de données par une séquence pseudo aléatoire selon le procédé de l'invention ;
- figure 3 : un exemple d'architecture de différentes ensembles de transpondeurs du satellite ayant des polarisations linéaires.

**DESCRIPTION**

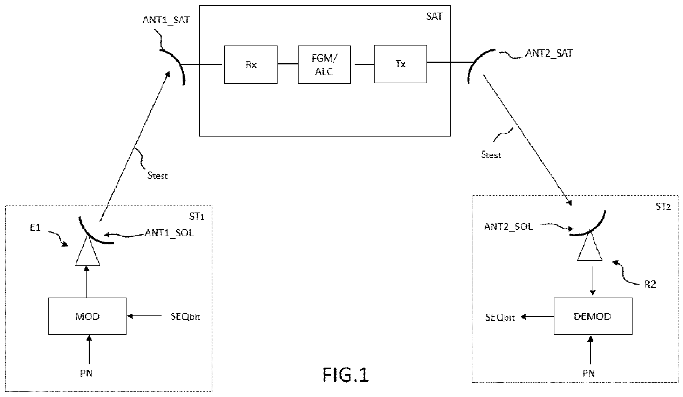

La figure 1 représente un exemple de réalisation du procédé et du système de l'invention.

Le procédé de l'invention permet d'établir une communication par voie radio d'une première station au sol ST1 vers une seconde station au sol ST2, la communication transitant par au moins un répéteur d'un satellite SAT géostationnaire.

Le but de l'invention est d'établir une cartographie de la couverture d'une antenne en émission ANT1_SOL au sol. Cette cartographie est réalisée en testant pour différentes orientations de l'antenne d'émission ANT1_SOL, certaines caractéristiques en réception d'un signal de test Stest empruntant la liaison de communication. Notamment, une mesure de la puissance reçue de chaque signal de test $S_{test}$ est effectuée par l'antenne de réception ANT2_SOL de la seconde station au sol ST2.

L'ensemble des mesures réalisées permet d'établir une cartographie de couverture de l'antenne d'émission ANT1_SOL.

La figure 1 représente une première station sol ST1 comprenant un émetteur E1 ayant une antenne d'émission à tester, notée ANT1_SOL.

La station sol ST1 comprend un modulateur MOD qui permet de moduler une séquence de bits de données $SEQ_{BIT}$ par une séquence pseudo aléatoire PN. Un calculateur permet de configurer le gain de traitement et d'encoder les données de la séquence $SEQ_{BIT}$. Ce calculateur n'est pas représenté sur la figure 1. Un moteur permet d'asservir l'orientation de l'antenne ANT1_SOL afin de parcourir un cône d'émission à tester. Les relevées de puissances reçues dans la seconde station au sol ST2 permettent de déduire une cartographie de couverture de l'antenne d'émission ANT1_SOL à la fin du test.

La station au sol ST1 comprend éventuellement un composant réseau pour être raccordé à un réseau de type internet ou téléphonique. Ce réseau peut être utilisé pour communiquer des données entre les deux stations sol ST1 et ST2. Ce dernier composant réseau n'est pas représenté sur la figure 1.

La figure 1 représente un signal de test Stest émis par la première station sol ST1 et reçu par le satellite SAT. Le satellite SAT comprend une antenne de réception ANT1_SAT d'un récepteur Rx. Le récepteur est connecté à un répéteur dont l'objectif est notamment d'amplifier un signal et de le retransmettre à une seconde station terrestre ST2.

A cette fin, le satellite comprend un émetteur Tx comprenant une antenne d'émission ANT2_SAT. Le signal de test Stest est réacheminé vers la seconde station sol ST2.

Le satellite peut être configuré dans un premier mode FGM introduisant un gain fixe d'amplification du signal testé $S_{test}$. Dans un second mode, le satellite SAT est configuré en mode ALC permettant d'assurer un gain fixe en sortie de l'antenne du satellite ANT2_SAT quelque soit le niveau d'entrée du signal de test $S_{test}$ en entrée du satellite. Dans ce dernier mode, le gain du répéteur est adapté et donc variable pour assurer une puissance fixe en sortie de l'émetteur du satellite SAT

La seconde station sol ST2 comprend un récepteur R2 comportant au moins une antenne de réception ANT2_SOL. Eventuellement, une seconde antenne ANT2_SOL(2) est utilisée pour capter la composante de polarisation croisée. Une seconde antenne en réception peut être également utilisée pour mesurer le niveau des interférences reçues. Un démodulateur DEMOD permet de démoduler le signal de test Stest pour déduire la séquence de bit de données $SEQ_{BIT}$. Le démodulateur DEMOD utilise la séquence PN utilisée par le modulateur de l'émetteur pour démoduler le signal de test $S_{test}$ en bande de base. La séquence PN est donc connue de l'émetteur de ST1 et du récepteur de ST2.

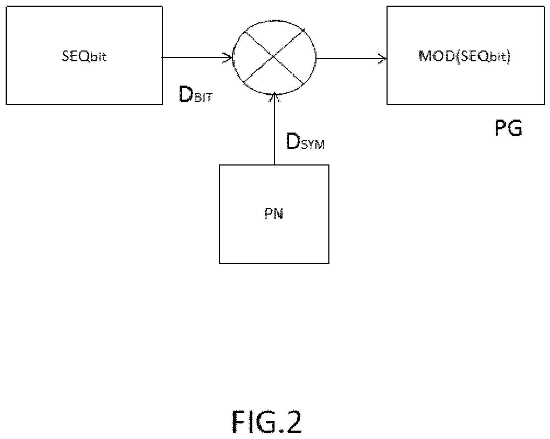

La figure 2 représente un diagramme représentant des blocs du modulateur MOD. La séquence $SEQ_{BIT}$ configuré avec un débit $D_{BIT}$ est modulée par la séquence PN configurée avec un débit $D_{SYM}$. Le modulateur MOD permet de générer une séquence étalée en spectre dans un canal ascendant en assurant un gain de traitement prédéterminé. Ce gain de traitement peut être configuré par un calculateur et piloté manuellement ou automatiquement, par exemple à distance.

**Station Sol Emission, Modulation**

Comme énoncé dans le cadre de la figure 1, une séquence de bits de données $SEQ_{bit}$ est modulée par une séquence PN de pseudo bruit de manière à étaler le spectre en fréquence dans la largeur du canal d'émission.

La séquence PN utilisée peut être une séquence DSSS signifiant dans la terminologie anglo-saxonne « Direct Sequence Spread Spectrum » également connue comme étalement de spectre à séquence directe dans la terminologie française.

Un signal de test $S_{test}$ est émis au moyen d'une fréquence porteuse. La modulation par étalement de spectre permet d'étaler la puissance du signal dans une bande de fréquence autour de la fréquence porteuse et de diminuer la densité de puissance émise par l'antenne d'émission ANT1_SOL. La densité de puissance émise peut être éventuellement noyée dans le bruit radio selon la configuration de la séquence PN utilisée.

Un avantage de l'utilisation d'une séquence de pseudo bruit PN est de limiter les interférences causées à d'autres systèmes radiofréquence par l'émission de signaux à fortes puissances.

**Puissance en émission**

La puissance émise du signal de test $S_{test}$ par l'antenne d'émission ANT1_SOL est configurée de sorte que la puissance soit constante pour une orientation donnée.

Selon un premier mode de réalisation, la puissance émise de chaque signal de test $S_{test}$ est identique pour chaque orientation d'antenne ANT1_SOL de sorte à bénéficier d'une référence commune.

Selon un second mode de réalisation, la puissance émise de chaque signal de test $S_{test}$ pour chaque orientation de l'antenne ANT1_SOL est configurée pour assurer une détection du signal par le satellite et par l'antenne de réception ANT2_SOL de la seconde station sol ST2.

Dans ce cas de figure, plusieurs variantes de réalisation sont possibles.

Selon une variante de réalisation, le récepteur de la seconde station sol ST2 ne connait pas à priori la puissance d'émission de chaque signal de test $S_{test}$ émis. La mesure de puissance du signal de test reçu $S_{test}$ est enregistrée dans une mémoire du récepteur de la seconde station sol ST2. Chaque mesure set ainsi enregistrée pour chaque orientation de l'antenne ANT1_SOL.

Les mesures en réception sont ensuite comparées à un ensemble de données de configuration enregistrées dans une mémoire de l'émetteur de la première station sol ST1. Pour effectuer cette comparaison, les mesures en réception au niveau de la seconde station sol ST2 et les données de configuration de chaque émission de la première station sol ST1 sont rapprochées par exemple en utilisant des données d'horodatage ou des données permettant d'associer chaque signal de test $S_{test}$ émis avec chaque signal de test $S_{test}$ reçu.

Le rapprochement peut être effectué par une transmission des mesures de réception enregistrées de la seconde station sol ST2 à la première station sol ST1. Réciproquement, les données de configuration de l'émetteur de la première station sol ST1 peuvent être transmises à un calculateur et une mémoire de la seconde station sol ST2 pour procéder aux comparaisons.

Selon les variantes de réalisation, les transmissions peuvent utiliser un réseau terrestre tel qu'un réseau internet ou encore une liaison sans fil. Dans ce dernier cas, les données ou mesures de la première station sol ST1 peuvent être transmises par un la liaison montante vers le satellite et retransmises par une liaison descendante à la seconde station sol ST2 ou réciproquement.

Selon une variante de réalisation, lorsqu'une liaison satellite est utilisée, un autre canal de transmission peut être utilisé, dans ce cas la liaison de données emprunte une autre voie du satellite, c'est-à-dire un autre répéteur.

Une autre variante particulièrement avantageuse de l'invention permet de coder les données de puissance de chaque émission de l'antenne d'émission ANT1_SOL dans la séquence de bits de données $SEQ_{BIT}$. Dans ce cas, en réception, le niveau du signal de test reçu $S_{test}$ est mesuré et enregistré. Le signal de test $S_{test}$ est démodulé et la séquence de bits de données $SEQ_{BIT}$ est décodée de sorte à extraire des données de configuration du test telles que la puissance émise en émission pour chaque orientation. D'autres données peuvent être codées comme par exemple l'orientation de l'antenne d'émission, ce qui est décrit ci-après dans la description.

Lorsque la puissance en émission est adaptée à chaque transmission, un paramètre de compensation est introduit pour corriger les mesures afin d'établir une cartographie de couverture de l'antenne d'émission ANT1_SOL homogène. En effet, lorsque l'antenne d'émission ANT1_SOL est en limite de portée vis-à-vis du satellite, une puissance maximale devrait être configurée en émission pour que le signal de test $S_{test}$ puisse être acheminé vers la seconde station sol ST2. Lorsque l'antenne pointe directement le satellite, une puissance moindre du signal de test $S_{test}$ est requise. Le paramètre de compensation permet de prendre en compte les écarts de puissance en émission pour établir un relevé de valeurs qui soient comparable afin d'établir une cartographie de couverture représentative des performances de l'antenne.

Les valeurs de puissances reçues en réception peuvent être :

- soient corrigées immédiatement au niveau du récepteur en intégrant chaque paramètre de compensation déduit de chaque puissance en émission lorsque cette dernière est communiquée dans la séquence de bits de données $SEQ_{BIT}$ ;
- soient non corrigées immédiatement, lorsque les mesures de puissances en réception sont communiquées à la première station de base après l'ensemble des tests de chaque orientation pour effectuer les calculs de couverture d'antenne dans un second temps.

**Orientation de l'antenne**

Le procédé comprend la détermination d'une de l'antenne ANT1_SOL de la station ST1. Pour chaque orientation, au moins une séquence de bits de données $SEQ_{BIT}$ est modulée par une séquence de pseudo-bruit PN de manière à étaler la puissance sur une bande de fréquences donnée.

Pour chaque signal de test $S_{test}$ émis, une orientation de l'antenne d'émission ANT1_SOL est déterminée. Selon le procédé de l'invention, le guidage de l'orientation de l'antenne ANT1_SOL parcourt un ensemble d'orientations définissant un cône d'angles à tester. La résolution ou « le pas » angulaire peut être définie par une configuration particulière du moteur pilotant l'antenne. Par exemple, à chaque changement d'orientation, un écart de 1° peut être défini entre deux orientations successives de l'antenne d'émission.

Le procédé de l'invention permet de définir et de configurer le balayage de l'antenne d'émission pour parcourir le cône à tester. Chaque mesure de puissance reçue dans la seconde station sol ST2 permet d'établir une cartographie de couverture de l'antenne d'émission ANT1_SOL.

Selon un mode de réalisation, un séquencement du balayage de l'antenne ANT1_SOL est prédéfini. La vitesse de balayage peut être préconfigurée et/ou pilotable par une commande manuelle ou automatique.

Selon un mode de réalisation, la seconde station au sol ST2 comprenant l'antenne de réception ANT2_SOL comprend un calculateur permettant d'émettre une consigne de guidage de l'orientation de l'antenne d'émission ANT1_SOL et de sa vitesse de balayage. Cette consigne peut être transmise par un réseau terrestre tel que le réseau internet ou téléphonique ou encore par un réseau sans fil par exemple utilisant un canal de transmission par voie satellitaire.

## Taux d'encodage - Gain de traitement

Le procédé de l'invention permet de déterminer la longueur de la séquence de bits de données $SEQ_{BIT}$ et le nombre de répétition de cette séquence dans le signal $S_{test}$ modulé par la séquence PN. La séquence $SEQ_{BIT}$ est caractérisée par un débit de transmission $D_{SEQ}$ d'un nombre de bits de données $N_{BIT}$ transmis par seconde.

Le procédé de l'invention permet également de déterminer la longueur de la séquence PN, c'est à dire le nombre de symboles présents dans la séquence PN. La séquence PN comprend une séquence de symboles et est caractérisé par un débit de transmission $D_{PN}$. La séquence PN comprend donc un débit $D_{PN}$ d'un nombre de symbole $N_{SYM}$ transmis par seconde.

La modulation de la séquence $SEQ_{BIT}$ par la séquence PN correspond à un encodage de chaque bit de données par une pluralité de symboles de la séquence PN. On définit ainsi un taux d'encodage qui correspond au rapport : $T_{COD} = D_{SYM} / D_{BIT}$.

Le taux d'encodage détermine un gain de traitement noté $G_T$ et exprimé en décibels dB. Le gain de traitement $G_T$ est un gain qui permet d'améliorer le rapport signal à bruit lors de l'opération de démodulation au niveau du récepteur de la seconde station sol ST2.

Ainsi la transmission d'une séquence $SEQ_{BIT}$ modulée par étalement de spectre par une séquence PN dans une bande de fréquences définissant un canal autour d'une porteuse d'un signal $S_{test}$ permet de diminuer la densité de puissance émise par l'antenne d'émission ANT1_SOL tout en conservant la possibilité de démoduler le signal en réception avec un gain de traitement bénéficiant à la détection du signal.

Selon un mode de réalisation, la séquence PN peut être répétée dans le signal de test $S_{test}$ un certain nombre de fois avec ou sans codage d'une séquence de bits de données $SEQ_{BIT}$ de sorte à augmenter les capacités de détection du signal de test en réception.

Selon un mode de réalisation, une pluralité de séquences PN sont émises dans le signal de test $S_{test}$ et au moins l'une d'entre elles est configurées pour coder la séquence de bits de données $SEQ_{BIT}$. Cette configuration permet d'une part d'augmenter le gain en réception et de faciliter la détection du signal et d'autres part, le codage d'au moins une séquence de bits de données permet de transmettre des données de configuration au récepteur, telles que la puissance émise, l'orientation de l'antenne ou la vitesse de balayage de l'antenne.

## Synchronisation

Selon un mode de réalisation, le procédé de l'invention comprend l'utilisation d'au moins une séquence PN qui permet d'établir une donnée de synchronisation. C'est-à-dire que la détection d'un signal de test $S_{test}$ peut constituer un marquage temporel tel qu'un horodatage. La détection du signal de test peut être effectuée par la détection d'un pic de puissance après démodulation du signal grâce à la connaissance de la séquence PN en réception et une autocorrélation de cette séquence.

La donnée de synchronisation permet notamment de définir des références temporelles entre l'émetteur et le récepteur. En outre, elle permet de répertorier les mesures sauvegardées et d'associer chaque mesure à un instant donné et donc d'y associer une orientation de l'antenne d'émission AN1_SOL. Par ailleurs, lorsque différentes polarisations du signal de test $S_{test}$ sont détectées en réception par l'antenne de réception ANT2_SOL, la donnée de synchronisation peut permettre d'associer ensemble différentes mesures selon différentes polarisations détectées du signal de test $S_{test}$ pour améliorer les mesures de puissances.

## Cross polarisation et Copolarisation

Le procédé de l'invention tire un avantage de l'utilisation d'un signal de test $S_{test}$ comprenant différentes composantes polarisées.

Selon un mode de réalisation, le signal de test $S_{test}$ émis par l'antenne d'émission ANT1_SOL est principalement polarisé selon une polarisation donnée, appelée copolarisation. Une composante de polarisation croisée avec la composante copolarisée est générée intrinsèquement à l'émission du signal de test $S_{test}$.

La puissance de la composante croisée en polarisation est atténuée vis-à-vis de la composante copolarisée. En effet, la densité de puissance utile du signal de test $S_{test}$ est principalement contenue dans la composante copolarisée.

Au niveau du satellite, le procédé de l'invention permet de configurer deux voies du répéteur permettant d'amplifier chacune une composante du signal. Dans ce mode de réalisation, on néglige les composantes de polarisations croisées des signaux retransmis vers la seconde station sol ST2 qui seraient induites par le satellite lui-même dans chaque voie.

Les amplificateurs du satellite peuvent être configurés préférentiellement avec un gain fixe maximal, par exemple dans le mode FGM dont l'acronyme signifie dans la terminologie anglo-saxonne « Fixed Gain Mode ». Lorsque le satellite est configuré sur un gain maximal, la plage dynamique de détection du récepteur de la seconde station au sol est maximale.

Au sol, dans ce mode de réalisation, le récepteur peut comprendre deux antennes de réceptions ANT2_SOL(1) et ANT2_SOL(2) pour détecter chaque composante polarisée : la composante copolarisée et la composante de polarisation croisée. Les deux antennes ANT2_SOL(1) et ANT2_SOL(2) sont donc configurées avec des polarisations orthogonales. La composante co-polarisée est la composante comprenant la plus grande densité de puissance et elle est naturellement détectée et démodulée par le récepteur de la seconde station sol ST2.

En fonction de l'orientation de l'antenne ANT1_SOL et de la puissance d'émission du signal de test $S_{test}$, le niveau reçu du signal de test $S_{test}$ en réception à la seconde station sol ST2 peut varier selon une large gamme de valeurs. Le rapport de puissance du signal utile sur le niveau de puissance du bruit peut varier et les détections des signaux utiles peuvent devenir difficiles à mettre en oeuvre. Différents cas de détection peuvent alors se produire selon les composantes de polarisation considérées.

Un premier facteur de gain peut être calculé par un calculateur du récepteur. Le premier facteur de gain est calculé en fonction de la puissance reçue de la composante copolarisée

Lorsque la puissance du signal de test $S_{test}$ est très faible selon la composante de polarisation croisée et que le récepteur ne détecte pas de composante croisée alors qu'une composante copolarisée est détectée, le procédé de l'invention permet de récupérer des informations issues de la réception de la composante copolarisée pour améliorer la détection de la composante de polarisation croisée. Parmi ces informations, au moins une référence en fréquence et/ou en temps des signaux détectés de la composante copolarisée peut être utilisée de manière à optimiser les seuils de détection en fréquence et/ou en temps de la composante de polarisation croisée.

Dans le cas d'une antenne de réception ANT2_SOL(2) dédiée à la détection de la composante croisée de polarisation, cette dernière peut être pilotée par une référence fréquentielle et temporelle déduite de la détection de l'antenne de réception de la copolarisation ANT2_SOL(1) du signal de test $S_{test}$ en démodulant la séquence de bits de données reçue.

Un second facteur de gain peut être calculé pour adapter automatiquement le gain de l'émetteur de la première station de base ST1. Par exemple, en pilotant un niveau de puissance plus élevée pour obtenir la composante croisée en polarisation. Dans ce dernier cas, une liaison terrestre ou sans fil, par exemple satellitaire peut être utilisée pour que le calculateur de la seconde station sol ST2 transmette le second facteur de gain à l'émetteur de la première station dol ST1.

Dans ce dernier cas, la variation de puissance en émission est bien entendue prise en compte dans la mesure en réception pour établir une cartographie de couverture représentative du fonctionnement de l'antenne d'émission ANT1_SOL.

**Usage de la séquence de bits de données**

Selon un mode de réalisation, la séquence de bits de données $SEQ_{BIT}$ peut être utilisée pour coder des informations de puissance de l'antenne d'émission ANT1_SOL pour chaque nouvelle orientation testée de l'antenne. En outre, l'orientation elle-même peut être codée dans la séquence de bits de données $SEQ_{BIT}$. Le procédé de l'invention permet donc de réaliser un test de puissance pour une orientation donnée de l'antenne d'émission ANT1_SOL tout en communiquant au récepteur de la seconde station sol ST2 des informations pouvant être exploitées pour améliorer la détection des signaux et pour enregistrer les mesures directement.

Selon un mode de réalisation pouvant être combiné au précédent, la séquence de bits de données $SEQ_{BIT}$ peut être répétée un certain nombre de fois dans le signal de test $S_{test}$. Dans ce cas, la séquence PN module plusieurs séquences de bits de données $SEQ_{BIT}$. La taille de la séquence PN peut être adaptée ou elle peut aussi être répétée. Lorsque la taille de la séquence de bits de données $SEQ_{BIT}$ modulée par la séquence PN est plus longue, alors la vitesse de balayage de l'antenne d'émission ANT1_SOL peut être adaptée pour correspondre à une plus longue durée de détection du signal de test $S_{test}$.

Le procédé permet donc d'adapter la longueur de la séquence de bits de données $SEQ_{BIT}$ pour permettre d'améliorer le gain de traitement au niveau du récepteur et donc le gain d'antenne.

De ce fait, si une seule séquence de bits de données $SEQ_{BIT}$ modulée par une séquence PN ne suffit pas à la détection, une réémission du signal de test $S_{test}$ avec un codage d'une pluralité de séquences $SEQ_{BIT}$ peut être opéré. Le procédé de l'invention permet de répéter la séquence de bits de données $SEQ_{BIT}$ dans le signal de test $S_{test}$ afin d'élever le seuil de détection. En effet, le fait d'augmenter la durée du signal de test Stest en répétant la séquence de bits de données $SEQ_{BIT}$ permet d'augmenter le temps d'intégration de chaque bit de données et donc d'augmenter la densité de puissance par bit de données reçu.

Lorsque la vitesse de balayage de l'antenne d'émission ANT1_SOL est réduite alors le temps de mesure en réception augmente pour analyser la séquence de bits de données répétée. Le gain de traitement étant amélioré, le récepteur a une plus large gamme de détection.

Le procédé de l'invention permet d'utiliser une ou deux composantes de polarisation en réception pour :

- générer une consigne de pilotage de la vitesse de balayage de l'antenne d'émission ANT1_SOL et/ou ;
- répéter un certain nombre de fois la séquence de bits de données $SEQ_{BIT}$ dans le signal de test pour $S_{test}$ obtenir un gain d'antenne en réception donné et/ou ;
- répéter un certain nombre de fois la séquence PN avec ou sans codage d'une séquence $SEQ_{BIT}$ afin d'améliorer la détection.

Un calculateur de l'émetteur de la première station sol permet selon un mode de réalisation de coder des informations de configuration de chaque test dans la séquence de bits de données telles que :

- l'orientation de l'antenne et/ou
- la vitesse de balayage courante et/ou ;
- la puissance d'émission du signal de test $S_{test}$.

Selon un autre mode de réalisation, si la séquence PN est courte, le procédé de l'invention permet de répéter la séquence PN un certain nombre de fois dans le signal de test $S_{test}$ afin d'augmenter le gain de traitement en réception et donc d'améliorer la détection du signal de test $S_{test}$. La répétition de la séquence PN peut être effectuée sans séquence de bits de données $SEQ_{BIT}$ puisque l'objectif est de détecter en réception la présence du signal de test $S_{test}$ afin d'adapter le gain en réception ou d'asservir l'émetteur par une consigne de puissance ou de vitesse de balayage.

Dans le cas, où deux antennes en réception sont configurées selon des polarisations orthogonales, la détection de la composante copolarisée permet de démoduler la séquence PN et de fournir à la seconde antenne une information permettant de réaliser une démodulation cohérente. La démodulation cohérente est réalisée par le partage de la séquence PN reçue par la première antenne ANT2_SOL(2) et démodulée par le récepteur avec le récepteur de la seconde antenne ANT2_SOL(2) détectant la composante de polarisation croisée. La corrélation des données attendues avec la séquence PN démodulée de la composante copolarisée permet d'augmenter les niveaux de détection de la composante de polarisation croisée.

## Pilotage Emetteur

Dans tous les modes de réalisation, la démodulation et le décodage des données de la séquence de bits de données $SEQ_{BIT}$ permet de déduire une consigne de pilotage de l'émetteur. Cette consigne peut être transmise automatiquement à partir d'un calculateur et d'un composant d'accès à un réseau de communication par voie terrestre ou satellitaire.

Ainsi la vitesse de balayage est modifiée grâce à une commande de pilotage du moteur. La résolution, c'est à dire le pas d'orientation de l'antenne, peut aussi être pilotée pour obtenir différentes mesures dans un cône d'orientation donné de l'antenne ANT1_SOL.

Selon un mode de réalisation, la vitesse de balayage de l'antenne d'émission ANT1_SOL peut comprendre une première pré-configuration. C'est-à-dire que dans la limite supposée de couverture, la vitesse de balayage de l'antenne est réduite permettant de répéter plusieurs séquences de bits de donnée $SEQ_{BIT}$ de sorte à augmenter le gain en réception et diminuer les seuils de détection de signaux. En revanche, lorsque l'antenne est dirigée selon une orientation pointant par exemple le satellite, la vitesse de balayage de l'antenne peut être plus rapide car les signaux de tests $S_{test}$ peuvent comprendre des séquences de bits de données $SEQ_{BIT}$ et des séquence PN plus courtes.

## Configuration satellite

Le procédé de l'invention peut être appliqué avec deux types de configurations des répéteurs du satellite SAT.

Un premier mode de configuration des répéteurs utilisés par le procédé de l'invention est le mode FGM qui permet de définir une puissance fixe dans chaque répéteur.

Le répéteur applique un même gain pour chaque signal de test $S_{test}$ à réémettre vers la station au sol ST2. Dans ce cas, le récepteur au sol mesure des variations de puissances fidèles aux variations dues aux changements d'orientation de l'antenne d'émission ANT1_SOL lors des tests.

Un second mode de configuration des répéteurs du satellite par le procédé de l'invention est le mode ALC. Le mode ALC permet d'ajuster le gain à appliquer au signal reçu par le satellite en fonction du niveau du signal reçu en entrée du satellite de sorte à délivrer en sortie du répéteur un niveau de signal fixe.

L'amplification des signaux au sein du satellite est pilotée dynamiquement. La bande de valeurs de gains à appliquer aux signaux en entrée du satellite permet d'amplifier ces derniers lorsque leur puissance est comprise dans une bande donnée. Les écarts de puissance reçue au niveau de l'antenne de réception du satellite sont alors compensés pour maintenir un niveau de puissance fixe en sortie de la chaine d'amplification.

Ainsi il est possible de mesurer les variations de gain appliqué au niveau de la chaine d'amplification du satellite pour en déduire le diagramme de l'antenne en émission, le test pouvant être réalisé pour un ensemble d'orientations de ladite antenne.

Les mesures de gains appliqués aux signaux d'entrée du satellite sont effectuées dynamiquement par le satellite. Ces mesures peuvent être enregistrées et/ou envoyées à une station au sol par exemple grâce à l'antenne de télémétrie du satellite.

De manière à améliorer la détection du signal en entrée du satellite lorsque le signal est bruité ou que son niveau est faible, le codage d'une séquence de bits selon le procédé de l'invention permet dans le satellite d'effectuer une meilleure détection. Les mesures sont réémises par exemple au sol via l'antenne de télémétrie. La séquence de bits peut être répétée ou la vitesse de balayage peut être ralentie de l'antenne d'émission au sol de sorte à augmenter le gain de réception à bord du satellite.

En considérant qu'aucune interférence sur la voie montante et sur la voie descendante ne soit présente et si le satellite est configuré dans un mode ALC, le répéteur amplifiera le signal reçu dans une plage nominale de gain. En réception, le niveau reçu peut être pronostiqué en connaissant les caractéristiques d'amplification du répéteur du satellite et en connaissant le niveau de puissance de l'antenne d'émission ANT1_SOL.

Ainsi les deux modes de configuration du satellite sont compatibles de l'invention et peuvent être utilisés conjointement. Par exemple, sur une certaine plage de valeurs de niveaux de puissance, le mode ALC est configuré et en dessous d'un certain seuil de puissance en entrée du satellite, un gain fixe est appliqué aux signaux reçus.

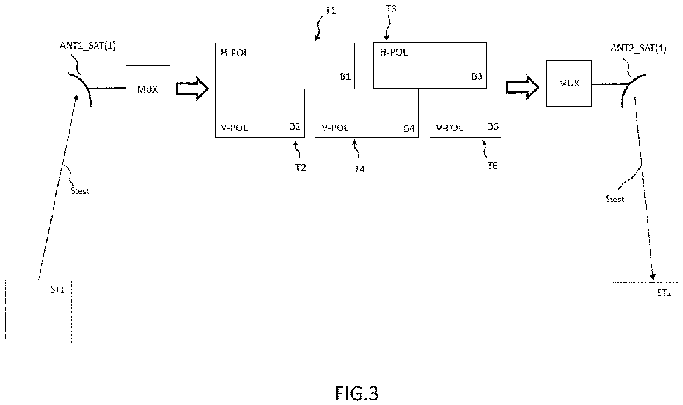

Selon un mode de réalisation, le satellite SAT comprend des transpondeurs configurés selon deux polarisations linéaires orthogonales. La figure 3 représente un exemple de réalisation, un premier ensemble de transpondeurs T1, T3 comprend une polarisation linéaire horizontale H-POL et un second ensemble de transpondeurs T2, T4, T6 comprend une polarisation verticale V-POL. Chaque transpondeur T1, T2, T3, T4, T6 comprend une bande en fréquence B1, B2, B3, B4, B6.

Un multiplexeur en entrée et en sortie du satellite SAT peuvent être utilisés pour allouer les différents signaux dans les différents transpondeurs en fonction des fréquences en réception et en émission et des bandes en fréquences de chaque transpondeur.

Les composantes co-polarisées et les composantes croisées du signal de test $S_{test}$ sont transmises et traitées par les transpondeurs ayant les polarisations appropriées auxdites composantes. Les signaux sont ensuite émis par chaque transpondeur du satellite SAT en sortie vers la seconde station au sol ST2.

**Gestion des interférences induites**

En réception, le signal de test reçu $S_{test}$ est multiplié par une séquence PN enregistrée et connue du récepteur de la seconde station sol ST2. La corrélation des données reçues et des données connues permet de déduire en bande de base la séquence de bits de données $SEQ_{BIT}$.

Les séquences de type PN permettent grâce à leurs très bonnes propriétés d'autocorrélation de détecter un signal même dans un niveau important de bruit.

Lorsque des signaux tiers sont détectés causant des interférences dans le signal total reçu, ces derniers sont éliminés grâce à la démodulation de la séquence PN. De ce fait, le procédé de l'invention permet de tester une cartographie d'une antenne d'émission tout en en diminuant la puissance à l'émission et en s'affranchissant d'interférences causées par la réception de signaux tiers. Le gain de traitement en réception est amélioré grâce à configuration des séquence(s) PN et séquence(s) $SEQ_{BIT}$ par le modulateur en émission.

La corrélation de la séquence PN connue avec une séquence démodulée génère un pic de puissance lorsque les deux séquences correspondent. La précision de la détection est réalisée au symbole près puisque la multiplication de deux séquences PN identiques permet d'obtenir une parfaite correspondance et un pic de puissance lors de la détection. La multiplication de deux séquences PN décalées d'un symbole donne une puissance noyée dans un niveau de bruit.

Suite à la démodulation de la séquence PN, l'énergie du signal utile devient importante vis-à-vis du bruit et du niveau des signaux d'interférences.

Lorsque les interférences sont reçues en entrée du satellite SAT et que les signaux d'interférences sont amplifiés par le satellite SAT, la démodulation en réception par le récepteur de la seconde station sol ST2 permet de déduire le signal utile grâce à la modulation par étalement de spectre.

En revanche, dans ce dernier cas, le satellite a amplifié un signal correspondant à la somme du signal de test $S_{test}$ et des interférences notées J. Si le répéteur est configuré dans un mode ALC, la puissance de sortie du satellite sera biaisée par la présence des interférences qui ont été amplifiées. Ainsi le niveau d'amplification du répéteur ne pourra pas être pris en compte tel quel pour déduire une donnée pertinente de couverture de l'antenne d'émission au sol ANT1_SOL.

Le procédé de l'invention permet de déduire la valeur de la puissance reçue liée aux interférences J en réception au sol pour générer un facteur de compensation des interférences $F_J$. Ce facteur $F_J$ permet de corriger le gain du satellite biaisé par la présence d'interférences dans la mesure enregistrée de puissance reçue.

Une première méthode comprend la mesure de puissance du signal $S_{test+}J$ avant la démodulation du signal de test $S_{test}$. Par exemple, cette mesure est réalisé à partir d'un analyseur de spectres. Selon une autre méthode, cette mesure est réalisée par l'utilisation de la transformée de Fourier discrète et par l'application du théorème de Parseval sur les niveaux numérisés.

Une seconde méthode comprend la réception du signal de test $S_{test}$ avec les interférences J dans deux voies différentes et identiques. Les signaux sont démodulés dans les deux voies. L'une des voies comprend un filtre réjecteur de bande de la bande de base du signal de test $S_{test}$ démodulé correspondant aux données de base démodulées.

La comparaison des deux signaux démodulés dans chaque voie permet d'obtenir la puissance des interférences J isolées en soustrayant les deux signaux des deux voies.

Lorsque la puissance liée à la présence d'interférences J est calculée, le facteur de compensation des interférences $F_J$ peut être pris en compte pour déduire les mesures de puissances reçues et des gains nécessaires à configurer pour l'antenne d'émission pour une orientation donnée.

Le facteur de compensation d'interférences $F_J$ peut être calculé pour chaque mesure correspondant à une orientation de l'antenne d'émission donnée ANT1_SOL. Ce facteur peut être mémorisé dans une mémoire de la seconde station sol ST2. Il peut être également transmis à la première station sol ST1.

Selon un autre mode de réalisation, l'antenne d'émission ANT1_SOL de la première station sol ST1 calibre chacune des puissances d'émission de l'antenne ANT1_SOL en fonction des dernières mesures de puissances d'interférences en prenant en compte le facteur de compensation d'interférences. Cette solution permet d'ajuster dynamiquement le niveau de puissance nécessaire en émission.

Un exemple de calcul de la puissance des interférences est donné ci-dessous.

Si on note $S_0$ la puissance du signal utile reçu et $J_0$ la puissance des interférences reçues à $t_0$. $EIRP_0$ est la puissance totale reçue par l'antenne de réception de la seconde station sol ST2. On a :

$$S_0 + J_0 = EIRP_0;$$

$S_0$ et $J_0$ peuvent être estimés comme énoncé précédemment.

On note le rapport $k_0 = S_0 / J_0$

Ce rapport peut être choisi dans un mode comme le facteur de compensation d'interférences ou il peut également permettre de le définir selon la définition donnée au facteur de compensation d'interférences.

On obtient

$$S_0 = EIRP_0 * (k_0/(k_0+1))$$

A l'instant suivant ti, correspondant à une nouvelle orientation de l'antenne d'émission ANT1_SOL, un calculateur de la station sol ST1 permet de calculer le facteur ki déduit des mesures à $t_0$.

La variation du niveau de sortie du signal à l'antenne d'émission sera calculé en fonction de la puissance reçue apparente EIRP de l'antenne de la seconde station sol ST2.

Les variations du signal de test reçu $S_{test}$ en réception peuvent être calculées entre deux émissions de l'antenne d'émission pour deux orientations différentes de l'antenne ANT1_SOL.

De la même manière on calcul la puissance utile du signal de test $S_{test}$ en entrée du récepteur du satellite pour prendre en compte le gain variable du satellite dans une configuration de type ALC.

**Détail de configurations opérationnelles**

**- Fréquence porteuse et largeur de bande**

Selon un mode réalisation, la fréquence porteuse peut être choisie, par exemple, dans une bande Ku ou tout autre bande en fréquences. Une fréquence porteuse assurant la voie montante vers le satellite peut par exemple être choisie égale à 13,78267 GHz avec une bande de 54MHz. Une fréquence porteuse assurant la voie descendante peut être choisie égale à 10,98267 GHz

La largeur de bande du canal utilisée dépend de la fonction d'étalement de spectre et donc le la taille de la séquence PN.

Selon un autre exemple, le canal de la voie montante peut avoir une largeur de 54MHz. Selon un autre exemple, le canal peut être encore plus étroit, par exemple de l'ordre de 5MHz. sur un canal de 72MHz

**- Codage, gain de traitement**

Selon un premier exemple, une séquence de bits de données transmise à 1k bits/s (1000 bits/s) peut être codée avec une séquence PN de 25 M symboles/s (25000000 symboles/s). Dans ce cas chaque bit de données est codé par 25000 symboles de la séquence PN. Le gain de traitement est de $10 \cdot \log_{10}(D_{SYM} / D_{BIT})$, c'est-à-dire de 44dB dans cet exemple.

Selon un second exemple, une séquence de bits de données transmise à 1k bits/s (1000 bits/s) peut être codée avec une séquence PN de 1 M symboles/s (1000000 symboles/s). Dans ce cas chaque bit de données est codé par 1000 symboles de la séquence PN.

Selon un troisième exemple, la séquence de bits de données $SEQ_{BIT}$ est transmise à un débit de 15kbit/s. La séquence de bits de données $SEQ_{BIT}$ est modulée par une séquence PN pseudo aléatoire de 3,84 Msymboles/s. Chaque bit de données est donc codé par 156 symboles. On obtient un gain de traitement GT de 24dB.

Selon un autre exemple de réalisation, une séquence PN d'un débit de 50 Msymboles/s permet de coder une séquence de bits de 100bits/s avec un gain de traitement $G_T$ de 57dB.

Ces exemples permettent de comprendre que le gain de traitement peut être déterminé avantageusement de manière élevée en considérant un rapport favorable entre la taille d'une séquence PN et la taille de la séquence de bits de données $SEQ_{BIT}$.

La séquence de bits de données n'a pas d'autre but que d'établir un test et de transmettre certaines informations utiles de configuration de l'émission selon le mode envisagé du procédé de l'invention.

Dans le mode le plus complet de l'invention, la puissance d'émission, l'orientation d'antenne et la vitesse de balayage sont transmises dans la séquence de bits de données $SEQ_{BIT}$. Dans ce cas de figure, un nombre limité de bits de données est nécessaire pour transmettre ces informations. De ce fait, la séquence de bits de données $SEQ_{BIT}$ peut être choisie relativement courte, c'est-à-dire comprendre par exemples quelques bits, une centaine de bits encore un millier de bits. D'autres exemples peuvent être choisis pour définir la longueur de la séquence de bits de données.

## Revendications

1. Procédé de mesure de gains d'antenne d'un émetteur ($E_1$) d'une première station terrestre ($ST_1$) pour la génération d'au moins une cartographie de couverture de ladite antenne, **caractérisé en ce que** le procédé comprend :

   ▪ Une pluralité d'émissions d'un signal de test ($S_{test}$) par un émetteur ($E_1$) d'une première station terrestre ($ST_1$) à destination d'un satellite (SAT) comprenant un répéteur pour retransmettre le signal de test ($S_{test}$) à une seconde station terrestre ($ST_2$), les émissions de l'émetteur ($E_1$) de la première station ($ST_1$) étant réalisées selon différentes orientations ($\theta_{i,i\in[1;N]}$) de l'antenne de l'émetteur ($E_1$), ledit signal de test ($S_{test}$) étant modulé par étalement de spectre dans un canal d'une largeur prédéterminée par une séquence numérique pseudo-aléatoire (PN) codant au moins une séquence de bits de données ($SEQ_{BIT}$) générée par un calculateur de l'émetteur ($E_1$);
   ▪ Une réception de chaque signal de test ($S_{test}$) par un récepteur ($R_2$) de la seconde station terrestre ($ST_2$) ;
   ▪ Une démodulation de chaque signal de test ($S_{test}$) permettant de mesurer la puissance reçue de chaque signal de test ($S_{test}$) ;
   ▪ Une comparaison de chaque puissance avec un premier seuil de référence de puissance prédéfinie (SEUIL_P) ;
   ▪ Une génération d'une consigne de codage (CONS_COD) visant à coder un nombre donné (N_SEQ) de séquences de bits de données ($SEQ_{BIT}$) par au moins une séquence pseudo-aléatoire (PN) dans un même signal de test ($S_{test}$) lorsque ladite puissance reçue d'un signal de test ($S_{test}$) est en dessous du premier seuil de puissance (SEUIL_P).

2. Procédé de mesure selon la revendication 1, **caractérisé en ce que** le signal de test généré comprend une pluralité de séquences PN, le nombre de séquence PN étant dépendant du niveau de puissance d'émission du signal de test ($S_{test}$) et de l'orientation de l'antenne (ANT1_SOL).

3. Procédé selon l'une quelconque des revendications 2, **caractérisé en ce que** la séquence de bits de données ($SEQ_{BIT}$) est une séquence comprenant que des bits de valeurs égales à 1 de sorte que la séquence reçue corresponde à la séquence PN.

4. Procédé de mesure selon l'une quelconque des revendications 1 à 3, **caractérisé en ce qu'**au moins une séquence de bits de données ($SEQ_{BIT}$) comprend des données codant l'orientation courante ($\theta_k$) de l'antenne d'émission de l'émetteur ($E_1$) de la première station terrestre ($ST_1$), ledit procédé comprenant un décodage de la séquence de bits de données ($SEQ_{BIT}$) par un calculateur du récepteur ($R_2$) de la seconde station terrestre ($ST_2$) pour assigner l'orientation angulaire courante de l'antenne de l'émetteur ($E_1$) décodée à la puissance du signal de test ($S_{test}$) mesurée en réception.

5. Procédé de mesure selon l'une quelconque des revendications 1 à 4, **caractérisé en ce que** :

   ▪ au moins une séquence de bits de données ($SEQ_{BIT}$) comprend, en outre, des données correspondant à la puissance d'émission de l'antenne de l'émetteur ($E_1$) de la première station terrestre ($ST_1$) ;
   ▪ au moins une séquence de bits de données ($SEQ_{BIT}$) comprend, en outre, des données correspondant à la vitesse de balayage de l'antenne de l'émetteur (E1) de la première station terrestre (ST1) ;
   ▪ au moins une séquence de bits de données ($SEQ_{BIT}$) comprend, en outre, des données correspondant à une calibration du signal de test ($S_{test}$) émis par l'antenne de l'émetteur (E1) de la première station terrestre (ST1).

6. Procédé de mesure selon l'une quelconque des revendications 1 à 7, **caractérisé en ce qu'**il comprend :

   ▪ une génération d'une consigne d'asservissement moteur (CONS_MOT) permettant de piloter la vitesse de balayage de l'antenne de l'émetteur ($E_1$) de la première station terrestre (ST1) en fonction du niveau de puissance mesurée du signal de test ($S_{test}$) reçu ;
   ▪ une génération d'une consigne d'asservissement moteur (CONS_MOT) permettant de piloter la vitesse de balayage de l'antenne de l'émetteur (E1) de la première station terrestre (ST1) en fonction de l'orientation de l'antenne correspondante à la mesure de la puissance mesurée du signal de test (Stest) reçu.

7. Procédé de mesure selon l'une quelconque des revendications 1 à 6, **caractérisé en ce que** le signal de test ($S_{test}$) comprend une composante d'onde copolarisée (COPOL), correspondante à la polarisation d'émission du signal et une composante d'onde cross-polarisée (CROSSPOL), correspondante à la polarisation orthogonale à la polarisation d'émission (COPOL), le répéteur du satellite amplifiant lesdites deux polarisations (COPOL, CROSSPOL), le récepteur ($R_2$) de la seconde station au sol ($ST_2$) démodulant les deux composantes orthogonales du signal de test ($S_{test}$), la mesure du puissance du signal de

test ($S_{test}$) comprenant une mesure de la puissance de la composante de polarisation d'émission (COPOL), ledit procédé comprenant en outre une étape de comparaison de ladite puissance de la composante de polarisation d'émission (COPOL) avec un second seuil de référence de puissance (SEUIL_COPOL) de manière à générer automatiquement une consigne de codage (CONS_COD) lorsque la valeur de la puissance est inférieure au second seuil de référence de puissance (SEUIL_COPOL).

8. Procédé de mesure selon la revendication 7, **caractérisé en ce que** la mesure du puissance du signal de test ($S_{test}$) comprend une mesure de puissance de la composante d'onde cross-polarisée (CROSSPOL) du signal de test ($S_{test}$) reçu par le récepteur ($R_2$) de la seconde station terrestre ($ST_2$) et **en ce qu'**une comparaison du niveau de puissance reçue de ladite composante cross-polarisée (CROSSPOL) avec un troisième seuil de référence de puissance (SEUIL_CROSSPOL) permet de générer une consigne de synchronisation (CONS_SYN), ladite consigne de synchronisation (CONS_SYN) permettant de prélever une donnée de référence fréquentielle (REF_FREQ) et/ou une donnée de référence temporelle (REF_TEMP) calculée à partir de la démodulation de la composante de polarisation d'émission (COPOL).

9. Procédé de mesure selon la revendication 8, **caractérisé en ce que** la génération d'une consigne de synchronisation (CONS_SYN) entraine la génération d'une consigne de codage (CONS_COD).

10. Procédé de mesure selon l'une quelconque des revendications 1 à 9, **caractérisé en ce qu'**au moins une consigne de codage (CONS_COD) et/ou au moins une consigne d'asservissement moteur (CONS_MOT) est automatiquement transmise à un calculateur du l'émetteur ($E_1$) de la première station terrestre ($ST_1$) par le biais d'un canal de retour.

11. Procédé de mesure selon la revendication 10, **caractérisé en ce que** le canal de retour est établi :

- Soit par l'intermédiaire d'un réseau terrestre ;
- Soit par l'intermédiaire d'un canal sans fil transitant par le satellite (SAT) et transmis à un récepteur ($R_1$) de la première station terrestre ($ST_1$).

12. Procédé de mesure selon l'une quelconque des revendications 1 à 11, **caractérisé en ce que** la vitesse de balayage de l'antenne de l'émetteur ($E_1$) de la première station terrestre ($ST_1$) est coordonnée avec le nombre (N_SES) de séquences de bits de données ($SEQ_{BIT}$) codée par au moins une séquence pseudo aléatoire (PN) de sorte que le balayage de l'antenne comprend des durées de maintien de l'antenne à une orientation donnée suffisamment longues pour qu'un signal de test ($S_{test}$) comprenant une pluralité de séquence de bits de données ($SEQ_{BIT}$) puisse être émis.

13. Procédé de mesure selon l'une quelconque des revendications 1 à 12, **caractérisé en ce qu'**une mesure des interférences (J) amplifiées par le répéteur du satellite est effectuée en réception par l'antenne de réception (ANT2_SOL) afin de déduire un facteur (k) de compensation des interférences (J) pour chaque mesure de puissance reçue.

14. Procédé de génération d'un ensemble de mesures pour l'établissement de la cartographie d'un diagramme d'émission d'une antenne d'un émetteur ($E_1$) d'une station terrestre ($ST_1$), **caractérisé en ce qu'**un ensemble de mesures de puissances reçues des signaux de test ($S_{test}$) par un récepteur d'une seconde station terrestre ($ST_2$) réalisé par le procédé de l'une quelconque des revendications 1 à 13, lesdites mesures de puissance étant chacune associée à une orientation de l'antenne de l'émetteur ($E_1$) de la première station terrestre ($ST_1$) et étant mémorisées dans une mémoire de la seconde station terrestre ($ST_2$).

15. Système comprenant :

- une première station au sol (ST1) comportant un générateur de signaux (MOD) permettant de coder une première séquence de bits de données ($SEQ_{bit}$) sur un signal de test ($S_{test}$) à émettre à partir d'une première antenne (ANT1_SOL) ;
- un satellite (SAT) comportant au moins une antenne de réception (ANT1_SAT) pour recevoir le signal de test ($S_{test}$), au moins un transpondeur (T1) pour réémettre le signal de test ($S_{test}$) amplifié vers une seconde station terrestre (ST2) ;
- une seconde station terrestre comportant au moins une antenne de réception (ANT2_SOL) et des moyens de calculs et de traitement du signal (DEMOD) pour démoduler le signal de test ($S_{test}$) reçu par le satellite (SAT) et générer automatiquement une consigne de codage selon le procédé de l'une quelconque des revendications 1 à 14.

**Patentansprüche**

1. Messverfahren von Antennenverstärkungen eines Senders ($E_1$) einer ersten terrestrischen Station ($ST_1$) für die Erzeugung wenigstens einer Abdeckungskartografie der genannten Antenne, **dadurch gekennzeichnet, dass** das Verfahren umfasst:

■ Eine Vielzahl von Übertragungen eines Testsignals ($S_{test}$) durch einen Sender ($E_1$) einer ersten terrestrischen Station ($ST_1$) für einen Satelliten (SAT), umfassend einen Zwischenverstärker zum Weiterleiten des Testsignals ($S_{test}$) an eine zweite terrestrische Station ($ST_2$), wobei die Übertragungen des Senders ($E_1$) der ersten Station ($ST_1$) gemäß unterschiedlichen Ausrichtungen ($\theta i$, $i\epsilon\{[1; N]\}$) der Antenne des Senders ($E_1$) realisiert sind, wobei das genannte Testsignal ($S_{test}$) per gespreiztem Spektrum in einem Kanal einer vorbestimmten Breite durch eine digitale pseudo-zufällige Sequenz (PN) moduliert ist, das wenigstens eine Sequenz von Datenbits ($SEQ_{BIT}$) kodiert, die durch einen Rechner des Senders ($E_1$) generiert ist;
■ Einen Empfang jedes Testsignals ($S_{test}$) durch einen Empfänger ($R_2$) der zweiten terrestrischen Station ($ST_2$);
■ Eine Demodulation jedes Testsignals ($S_{test}$), das die Messung der von jedem Testsignal ($S_{test}$) empfangenen Leistung zulässt;
■ Einen Vergleich jeder Leistung mit einem ersten Schwellenwert einer vorbestimmten Referenzleistung (SEUL_P);
■ Eine Generierung einer Codierungsvorschrift (CONS_COD), die eine bestimmte Anzahl (N_SEQ) von Datenbitsequenzen ($SEQ_{BIT}$) durch wenigstens eine pseudo-zufällige Sequenz (PN) in einem und demselben Testsignal ($S_{test}$) kodieren soll, wenn die genannte empfangene Leistung eines Testsignals ($S_{test}$) unterhalb des ersten Leistungsschwellenwertes (SEUIL_P) liegt.

2. Messverfahren gemäß Anspruch 1, **dadurch gekennzeichnet, dass** das generierte Testsignal eine Vielzahl von Sequenzen PN umfasst, wobei die Anzahl der Sequenzen PN von dem Sendeleistungsniveau des Testsignals ($S_{test}$) und der Ausrichtung der Antenne (ANT1_SOL) abhängt.

3. Verfahren gemäß irgendeinem der Ansprüche 2, **dadurch gekennzeichnet, dass** die Sequenz von Datenbits ($SEQ_{BIT}$) eine Sequenz ist, umfassend nur Bits mit Werten gleich 1 derart, dass die empfangene Sequenz der Sequenz PN entspricht.

4. Messverfahren gemäß irgendeinem der Ansprüche 1 bis 3, **dadurch gekennzeichnet, dass** wenigstens eine Sequenz von Datenbits ($SEQ_{BIT}$) Daten umfasst, die die laufende Ausrichtung ($\theta k$) der Senderantenne des Senders ($E_1$) der ersten terrestrischen Station ($ST_1$) umfasst, wobei das genannte Verfahren eine Dekodierung der Sequenz von Datenbits ($SEQ_{BIT}$) durch einen Rechner des Empfängers ($R_2$) der zweiten terrestrischen Station ($ST_2$) zum Zuordnen der laufenden winkelförmigen Ausrichtung der Antenne des Senders ($E_1$) umfasst, die auf die Leistung des beim Empfang gemessenen Testsignals ($S_{test}$) dekodiert ist.

5. Messverfahren gemäß irgendeinem der Ansprüche 1 bis 4, **dadurch gekennzeichnet, dass**:

■ wenigstens eine Sequenz von Datenbits ($SEQ_{BIT}$) darüber hinaus Daten umfasst, die der Sendeleistung der Senderantenne ($E_1$) der ersten terrestrischen Station ($ST_1$) entspricht;
■ wenigstens eine Sequenz von Datenbits ($SEQ_{BIT}$) darüber hinaus Daten umfasst, die der Abtastgeschwindigkeit der Antenne des Senders ($E_1$) der ersten terrestrischen Station ($ST_1$) entsprechen;
■ wenigstens eine Sequenz von Datenbits ($SEQ_{BIT}$) darüber hinaus Daten umfasst, die einer Eichung des von der Antenne des Senders ($E_1$) der ersten terrestrischen Station ($ST_1$) gesendeten Testsignals (Stest) entspricht.

6. Messverfahren gemäß irgendeinem der Ansprüche 1 bis 7, **dadurch gekennzeichnet, dass** es umfasst:

■ eine Generierung einer Motorsteuerungsvorschrift (CONS_MOT), die das Steuern der Abtastgeschwindigkeit der Antenne des Senders ($E_1$) der ersten terrestrischen Station ($ST_1$) in Abhängigkeit von dem gemessenen Leistungsniveau des empfangenen Testsignals ($S_{test}$) zulässt;
■ eine Generierung einer Motorsteuerungsvorschrift (CONS_MOT), die das Steuern der Abtastgeschwindigkeit der Antenne des Senders ($E_1$) der ersten terrestrischen Station ($ST_1$) in Abhängigkeit von der Ausrichtung der Antenne zulässt, die der Messung der gemessenen Leistung des empfangene Testsignals ($S_{test}$) entspricht.

7. Messverfahren gemäß irgendeinem der Ansprüche 1 bis 6, **dadurch gekennzeichnet, dass** das Testsignal ($S_{test}$) eine kopolarisierte Wellenkomponente (COPOL), die der Sendepolarisation des Signals entspricht, und eine kopolarisierte Wellenkomponente (CROSSPOL), die der zur Sendepolarisation (COPOL) orthogonalen Polarisation entspricht, umfasst, wobei der Zwischenverstärker des Satelliten die genannten zwei Polarisationen (COPOL, CROSSPOL) verstärkt, wobei der Zwischenverstärker ($R_2$) der zweiten Station am Boden ($ST_2$) die zwei orthogonalen Komponenten des Testsignals ($S_{test}$) demoduliert, wobei die Messung der Leistung des

Testsignals ($S_{test}$) eine Messung der Leistung der Komponenten der Sendepolarisation (COPOL) umfasst, wobei das genannte Verfahren darüber hinaus einen Vergleichsschritt der genannten Leistung der Komponente der Sendepolarisation (COPOL) mit einem zweiten Schwellenwert der Referenzleistung (SEUIL_COPOL) derart umfasst, dass automatisch eine Kodierungsvorschrift (CONS_COD) generiert wird, wenn der Wert der Leistung niedriger ist als der zweite Schwellenwert der Leistungsreferenz (SEUIL_COPOL).

8. Messverfahren gemäß Anspruch 7, **dadurch gekennzeichnet, dass** die Messung der Leistung des Testsignals ($S_{test}$) eine Leistungsmessung der kreuzpolarisierten Wellenkomponente (CROSSPOL) des von dem Empfänger ($R_2$) der zweiten terrestrischen Station ($ST_2$) empfangenen Testsignals ($S_{test}$) umfasst und dass ein Vergleich des empfangenen Leistungsniveaus der genannten kreuzpolarisierten Komponente (CROSSPOL) mit einem dritten Schwellenwert der Leistungsreferenz (SEUIL_CROSSPOL) die Generierung eines Synchronisationsschwellenwertes (CONS_SYN) zulässt, wobei der genannte Synchronisationsschwellenwert (CONS_SYN) die Entnahme einer Frequenzreferenzangabe (REF_FREQ) und / oder einer zeitlichen Referenzangabe (REF_TEMP), die ausgehend von der Demodulation der Komponente der Sendepolarisation (COPOL) berechnet ist.

9. Messverfahren gemäß Anspruch 8, **dadurch gekennzeichnet, dass** die Generierung einer Synchronisationsvorschrift (CONS_SYN) die Generierung einer Kodierungsvorschrift (CONS_COD) nach sich zieht.

10. Messverfahren gemäß irgendeinem der Ansprüche 1 bis 9, **dadurch gekennzeichnet, dass** wenigstens eine Kodierungsvorschrift (CONS_COD) und / oder wenigstens eine Motorsteuerungsvorschrift (CONS_MOT) automatisch auf einen Rechner des Senders ($E_1$) der ersten terrestrischen Station ($ST_1$) mittels eines Rückkanals übertragen wird.

11. Messverfahren gemäß Anspruch 10, **dadurch gekennzeichnet, dass** der Rückkanal erstellt ist:

    ■ Entweder mittels eines terrestrischen Netzes;
    ■ Oder mittels eines drahtlosen Kanals, der durch den Satelliten (SAT) hindurchtritt und auf einen Empfänger ($R_1$) der ersten terrestrischen Station ($ST_1$) übertragen wird.

12. Messverfahren gemäß irgendeinem der Ansprüche 1 bis 11, **dadurch gekennzeichnet, dass** die Abtastgeschwindigkeit der Antenne des Senders ($E_1$) der ersten terrestrischen Station ($ST_1$) mit der Anzahl (N_SES) von Sequenzen von Datenbits ($SEQ_{BIT}$) koordiniert ist, die durch wenigstens eine pseudozufällige Sequenz (PN) derart kodiert ist, dass das Abtasten der Antenne Haltedauern der Antenne in einer bestimmten Ausrichtung umfasst, die ausreichend lang sind, damit ein Testsignal ($S_{test}$), das eine Vielzahl von Sequenzen von Bitdaten ($SEQ_{BIT}$) umfasst, gesendet werden kann.

13. Messverfahren gemäß irgendeinem der Ansprüche 1 bis 12, **dadurch gekennzeichnet, dass** eine Messung der Interferenzen (J), die durch den Zwischenverstärker des Satelliten verstärkt sind, beim Empfang durch die Empfangsantenne (ANT2_SOL) durch die durchgeführt wird, um einen Ausgleichsfaktor (k) der Interferenzen (J) für jede empfangene Leistungsmessung abzuleiten.

14. Generierungsverfahren einer Gruppe von Messungen für die Erstellung der Kartografie eines Sendediagramms einer Antenne eines Senders ($E_1$) einer terrestrischen Station ($ST_1$), **dadurch gekennzeichnet, dass** eine Gruppe von von einen Empfänger einer zweiten terrestrischen Station ($ST_2$) empfangenen Leistungsmessungen der Testsignale ($S_{test}$), die durch das Verfahrung irgendeines der Ansprüche 1 bis 13 realisiert ist, wobei die genannten Leistungsmessungen jeweils einer Ausrichtung der Antenne des Senders ($E_1$) der ersten terrestrischen Station ($ST_1$) zugeordnet sind und in einem Speicher der zweiten terrestrischen Station ($ST_2$) gespeichert sind.

15. System, umfassend:

    ■ eine erste Station am Boden ($ST_1$), umfassend einen Signalgenerator (MOD), der das Kodieren einer ersten Sequenz von Datenbits ($SEQ_{bit}$) auf einem Testsignal ($S_{test}$) zulässt, das ausgehend von einer ersten Antenne (ANT1_SOL) zu senden ist;
    ■ einen Satelliten (SAT), umfassend wenigstens eine Empfangsantenne (ANT1_SAT) zum Empfangen des Testsignals ($S_{test}$), wenigstens einen Transponder (T1) zum erneuten Senden des verstärkten Testsignals ($S_{test}$) zu einer zweiten terrestrischen Station (ST2);
    ■ eine zweite terrestrische Station, umfassend wenigstens eine Empfangsantenne (ANT2_SOL) und Berechnungs- und Behandlungsmittel des Signals (DEMOD) zum Demodulieren des von dem Satelliten (SAT) empfangenen Testsignals ($S_{test}$) und automatisches Generieren einer Kodierungsvorschrift gemäß dem Verfahren nach irgendeinem der Ansprüche 1 bis 14.

## Claims

1. A method for measuring antenna gains of a transmitter ($E_1$) of a first terrestrial station ($ST_1$) for generating at least one coverage mapping of said antenna, **characterised in that** the method comprises:

   - a plurality of transmissions of a test signal ($S_{test}$) by a transmitter ($E_1$) from a first terrestrial station ($ST_1$) to a satellite (SAT) comprising a transponder for retransmitting the test signal ($S_{test}$) to a second terrestrial station ($ST_2$), the plural transmitting of the transmitter ($E_1$) from the first station (ST1) being made according to different orientations ($\theta_{i,i\in[1;N]}$) of the antenna of the transmitter ($E_1$), said test signal ($S_{test}$) being spread spectrum modulated in a channel with a predetermined width by a pseudo-random digital sequence (PN) coding at least one data bit sequence ($SEQ_{BIT}$) generated by a calculator of the transmitter ($E_1$);
   - receiving each test signal ($S_{test}$) by a receiver ($R_2$) of the second terrestrial station ($ST_2$);
   - demodulating each test signal ($S_{test}$) enabling the power received from each test signal ($S_{test}$) to be measured;
   - comparing each power with a first predefined power reference threshold (SEUIL_P);
   - generating a coding setpoint (CONS_COD) aiming at coding a given number (N_SEQ) of data bit sequences ($SEQ_{BIT}$) by at least one pseudo-random sequence (PN) in a same test signal ($S_{test}$) when said power received from a test signal ($S_{test}$) is below the first power threshold (SEUIL_P).

2. The measuring method according to claim 1, **characterised in that** the generated test signal comprises a plurality of PN sequences, the number of PN sequences being dependent on the emission power level of the test signal ($S_{test}$) and the orientation of the antenna (ANT1_SOL).

3. The method according to any of claims 2, **characterised in that** the data bit sequence ($SEQ_{BIT}$) is a sequence only comprising bits with values equal to 1 such that the sequence received corresponds to the PN sequence.

4. The measuring method according to any of claims 1 to 3, **characterised in that** at least one data bit sequence ($SEQ_{BIT}$) comprises data coding the current orientation ($\theta_k$) of the transmission antenna of the transmitter ($E_1$) of the first terrestrial station ($ST_1$), said method comprising decoding the data bit sequence ($SEQ_{BIT}$) by a calculator of the receiver ($R_2$) of the second terrestrial station ($ST_2$) to assign the current angular orientation of the antenna of the transmitter ($E_1$) decoded at the power of the test signal ($S_{test}$) measured upon reception.

5. The measuring method according to any of claims 1 to 4, **characterised in that**:

   - at least one data bit sequence ($SEQ_{BIT}$) further comprises data corresponding to the transmission power of the antenna of the transmitter ($E_1$) of the first terrestrial station ($ST_1$);
   - at least one data bit sequence ($SEQ_{BIT}$) further comprises data corresponding to the scanning rate of the antenna of the transmitter ($E_1$) of the first terrestrial station ($ST_1$);
   - at least one data bit sequence ($SEQ_{BIT}$) further comprises data corresponding to a calibration of the test signal ($S_{test}$) transmitted by the antenna of the transmitter ($E_1$) from the first terrestrial station ($ST_1$).

6. The measuring method according to any of claims 1 to 7, **characterised in that** it comprises:

   - generating a motor control setpoint (CONS_MOT) enabling the scanning rate of the antenna of the transmitter ($E_1$) of the first terrestrial station (ST1) to be driven as a function of the measured power level of the received test signal ($S_{test}$);
   - generating a motor control setpoint (CONS_MOT) enabling the scanning rate of the antenna of the transmitter (E1) of the first terrestrial station (ST1) to be driven as a function of the orientation of the antenna corresponding to the measurement of the measured power of the received test signal ($S_{test}$).

7. The measuring method according to any of claims 1 to 6, **characterised in that** the test signal ($S_{test}$) comprises a co-polarised wave component (COPOL), corresponding to the transmission polarisation of the signal and a cross-polarised wave component (CROSSPOL), corresponding to the polarisation orthogonal to the transmission polarisation (COPOL), the transponder of the satellite amplifying said two polarisations (COPOL, CROSSPOL), the receiver ($R_2$) of the second ground station ($ST_2$) demodulating both orthogonal components of the test signal ($S_{test}$), the measurement of the power of the test signal ($S_{test}$) comprising measuring the power of the transmission polarisation component (COPOL), said method further comprising a step of comparing said power of the transmission polarisation component (COPOL) with a second power reference threshold (SEUIL_COPOL) so as to automatically generate a coding setpoint (CONS_COD) when the power value is lower than the second power reference threshold (SEUIL_COPOL).

8. The measuring method according to claim 7, **characterised in that** measuring the power of the test signal ($S_{test}$) comprises measuring the power of the cross-polarised wave component (CROSSPOL) of the test signal ($S_{test}$) received by the receiver ($R_2$) of the second terrestrial station ($ST_2$) and **in that** a comparison of the power level received from said cross-polarised component (CROSSPOL) with a third power reference threshold (SEUIL_CROSSPOL) enables a synchronisation setpoint (CONS_SYN) to be generated, said synchronisation setpoint (CONS_SYN) enabling a frequency reference datum (REF_FREQ) and/or a time reference datum (REF_TEMP) calculated from demodulating the transmission polarisation component (COPOL) to be sampled.

9. The measuring method according to claim 8, **characterised in that** generating a synchronisation setpoint (CONS_SYN) causes generating a coding setpoint (CONS_COD).

10. The measuring method according to any of claims 1 to 9, **characterised in that** at least one coding setpoint (CONS_COD) and/or at least one motor control setpoint (CONS_MOT) are automatically transmitted to a calculator of the transmitter ($E_1$) of the first terrestrial station ($ST_1$) through a feedback channel.

11. The measuring method according to claim 10, **characterised in that** the feedback channel is set:

   - either through a terrestrial network;
   - or through a wireless channel passing through the satellite (SAT) and transmitted to a receiver ($R_1$) of the first terrestrial station ($ST_1$).

12. The measuring method according to any of claims 1 to 11, **characterised in that** the scanning rate of the antenna of the transmitter ($E_1$) of the first terrestrial station ($ST_1$) is coordinated with the number (N_SES) of data bit sequences ($SEQ_{BIT}$) coded by at least one pseudo-random sequence (PN) such that the antenna scanning comprises sufficiently long antenna holding durations at a given orientation for a test signal ($S_{test}$) comprising a plurality of data bit sequences ($SEQ_{BIT}$) to be able to be transmitted.

13. The measuring method according to any of claims 1 to 12, **characterised in that** measuring the interference (J) amplified by the satellite transponder is made upon reception by the reception antenna (ANT2_SOL) in order to deduce a compensation factor (k) of the interference (J) for each received power measurement.

14. A method for generating a set of measurements for setting the mapping of a transmission diagram of an antenna of a transmitter ($E_1$) of a terrestrial station ($ST_1$), **characterised in that** a set of measurements of powers received from the test signals ($S_{test}$) by a receiver of a second terrestrial station ($ST_2$) is made by the method of any of claims 1 to 13, said power measurements being each associated with an orientation of the antenna of the transmitter ($E_1$) of the first terrestrial station ($ST_1$) and being stored in a memory of the second terrestrial station ($ST_2$).

15. A system comprising:

   - a first ground station (ST1) including a signal generator (MOD) enabling a first data bit sequence ($SEQ_{bit}$) to be coded to a test signal ($S_{test}$) to be transmitted from a first antenna (ANT1_SOL);
   - a satellite (SAT) comprising at least one reception antenna (ANT1_SAT) to receive the test signal ($S_{test}$), at least one transponder (T1) for retransmitting the amplified test signal ($S_{test}$) to a second terrestrial station ($ST_2$);
   - a second terrestrial station including at least one reception antenna (ANT2_SOL) and signal calculation and processing means (DEMOD) for demodulating the test signal ($S_{test}$) received by the satellite (SAT) and automatically generating a coding setpoint according to the method of any of claims 1 to 14.

FIG.1

SEQbit

$D_{BIT}$

PN

$D_{SYM}$

MOD(SEQbit)

PG

FIG.2

FIG.3

**EP 3 026 453 B1**

**RÉFÉRENCES CITÉES DANS LA DESCRIPTION**

**Documents brevets cités dans la description**

- EP 2629439 A